Europäisches Patentamt

**European Patent Office**

Office européen des brevets

(19)

(11) Veröffentlichungsnummer: **0 043 991**
**B1**

(12) **EUROPÄISCHE PATENTSCHRIFT**

(45) Veröffentlichungstag der Patentschrift:
23.01.85

(51) Int. Cl.⁴: **G 03 F 7/26**

(21) Anmeldenummer: **81105123.4**

(22) Anmeldetag: **02.07.81**

(54) **Verfahren zum Einbrennen von lichtempfindlichen Schichten bei der Herstellung von Druckformen.**

(30) Priorität: **11.07.80 US 167615**

(43) Veröffentlichungstag der Anmeldung:
**20.01.82 Patentblatt 82/3**

(45) Bekanntmachung des Hinweises auf die Patenterteilung:
**23.01.85 Patentblatt 85/4**

(84) Benannte Vertragsstaaten:
**DE FR GB IT NL**

(56) Entgegenhaltungen:
**DE - A - 2 626 473**
**GB - A - 2 008 495**
**US - A - 3 262 780**

(73) Patentinhaber: **AMERICAN HOECHST CORPORATION, Route 202-206 North, Somerville, N.J. 08876 (US)**

(72) Erfinder: **Walls, John E., 46 Center Street, Annandale New Jersey 08801 (US)**

(74) Vertreter: **Euler, Kurt Emil, Dr. et al, KALLE Niederlassung der Hoechst AG Rheingaustrasse 190 Postfach 3540, D-6200 Wiesbaden 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**0 043 991**

**Beschreibung**

Die vorliegende Erfindung betrifft ein Verfahren zum Einbrennen von belichteten und entwickelten lichtempfindlichen Schichten während der Herstellung von Offsetdruckformen.

Positiv arbeitende lichtempfindliche Offsetdruckplatten werden gewöhnlich hergestellt, indem ein Träger aus Metall wie Aluminium oder auf Basis organischer Polymerer mit einer lichtempfindlichen Schicht versehen wird, die als lichtempfindliche Verbindung ein o-Naphthochinondiazid enthält, das entweder allein oder mit entsprechenden Zusätzen wie Bindemitteln und/oder Farbstoffen kombiniert vorliegen kann. Nach der Belichtung dieser lichtempfindlichen Druckplatte durch ein transparentes Positiv zersetzt sich die lichtempfindliche Verbindung an den belichteten Stellen und die lichtempfindliche Schicht wird an diesen Stellen relativ löslicher; zur Entwicklung können diese Stellen deshalb leicht mit einer wäßrig-alkalischen Lösung entfernt werden, wobei auf dem Träger ein positives Bild der Vorlage entsteht (Druckformherstellung). Üblicherweise wird ein Träger benutzt, dessen Oberfläche hydrophil ist, bzw. zuvor durch eine spezielle Behandlung hydrophiliert worden ist, wobei dann bei der Entwicklung der belichteten lichtempfindlichen Schicht Teile der hydrophilen Trägeroberfläche freigelegt werden, die beim späteren Drucken wasserannehmend und farbabstoßend sind (Nichtbildstellen). Andererseits sind die zurückbleibenden Bildstellen oleophil und somit farbannehmend.

Negativ arbeitende Offsetdruckplatten enthalten oft Azidoverbindungen, Diazoniumsalze oder photopolymerisierbare Verbindungen als lichtempfindliche Verbindungen. Es werden bei diesen Druckplatten die unbelichteten Stellen mit Entwickler entfernt, wobei die hydrophile, wasserannehmende und farbabstoßende Oberfläche des Druckplattenträgers freigelegt wird. Dagegen sind die Stellen, die durch Belichtung gehärtet werden und nach dem Entwickeln als Bildstellen erhalten bleiben, oleophil und farbannehmend.

Es ist aus dem Stand der Technik des Offsetdrucks bekannt, die Anzahl der mit Offsetdruckformsystemen zu erzielenden Drucke auf ein Vielfaches zu steigern, indem man diese Druckformen nach dem Belichten und Entwickeln stark erhitzt. Bei diesen erhöhten Temperaturen findet wahrscheinlich eine Vernetzung von Bestandteilen der Bildstellen statt, die zu einer praktisch vollständigen Unlöslichkeit in organischen Lösemitteln, zu erhöhter Abriebfestigkeit und zu einer erheblich längeren Standzeit führt; dieses Aufheizen wird im allgemeinen »Einbrennen« genannt. Aus dem Stand der Technik sind beispielsweise folgende Verfahren bekannt:

In der DE-B-854 890 ( = US-A-3 046 121) wird die Nachbehandlung von positiv arbeitenden, Diazoverbindungen enthaltenden lichtempfindlichen Schichten durch Erhitzen der diese Schichten aufweisenden Druckplatten beschrieben. Das Erhitzen wird vor oder nach der Entwicklung der belichteten Druckplatte durch Behandlung mit Flammen, mit einem heißen Bügeleisen, in einem elektrisch auf höhere Temperaturen geheizten Kasten oder zwischen geheizten Walzen bewirkt; die unbelichtete Diazoverbindung soll durch das Erhitzen zersetzt, und das Zersetzungsprodukt fest mit dem Trägermaterial verbunden werden.

Aus der DE-B-1 447 963 ( = GB-A-1 154 749) ist ein Verfahren zum Herstellen einer Offsetdruckform bekannt, bei dem die Druckplatten mit positiv arbeitenden, o-Naphthochinondiazidverbindungen enthaltenden lichtempfindlichen Schichten nach dem Entwickeln in Gegenwart eines Novolaks und/oder eines Resols auf eine Temperatur von mindestens 180° C erhitzt werden. Das Harz ist entweder bereits in der lichtempfindlichen Schicht vorhanden oder wird vor dem Erhitzen in Lösung auf die lichtempfindliche Schicht aufgebracht. Die Höhe der Erhitzungstemperatur und die Erhitzungsdauer werden so gewählt, daß durch Zersetzen der farbführenden (nicht vom Licht getroffenen) Bildstellen ein Niederschlag auf den beim Drucken wasserführenden (durch den Entwickler entfernten, vom Licht getroffenen) Teilen der Druckplatte entsteht; durch eine Nachbehandlung werden dann diese beim Drucken wasserführenden Teile der Druckplatte wieder gesäubert. Die Erhitzungstemperatur soll insbesondere bei 200° bis 250° C liegen, die zugehörige Erhitzungsdauer beträgt dann 5 bis 60 min; die Erhitzung wird in einem Einbrennofen durchgeführt. Ein vergleichbares Verfahren für das Einbrennen von negativ arbeitenden, ein p-Chinondiazid, eine Diazonium- oder Azidoverbindung enthaltenden lichtempfindlichen Schichten wird in der DE-B-1 447 962 ( = GB-A-1 151 199) beschrieben.

Ein typischer, an sich unerwünschter Nebeneffekt des Einbrennvorgangs ist, daß sich die Eigenschaften der Oberfläche von beispielsweise Aluminiumträgern von hydrophil zu oleophil verändern können. Wahrscheinlich gehen an der Grenzfläche vorhandene Aluminiumoxide, durch hohe Umgebungstemperaturen katalysiert, komplexe Umlagerungen ein, die zu einer Verschiebung des hydrophil/hydrophoben Gleichgewichts führen.

Wenn beim späteren Drucken Spezialdruckfarben verwendet werden, die auch Bestandteile enthalten können, welche die Bildstellen auf der Druckform auflösen oder zumindest anlösen oder anquellen (z. B. UV-härtbare Farbe, eine bei niedrigen Temperaturen härtbare Farbe usw.), werden die Bildstellen von auf herkömmliche Weise hergestellten Druckformen durch diese Farben stark verändert, wodurch sich — verglichen mit Fällen, wo eine gewöhnliche Druckfarbe verwendet wird — beispielsweise die Standzeiten dieser Platten erheblich verkürzen. Durch Einbrennen der Druckformen kann jedoch auf bei Gebrauch der oben erwähnten Spezialfarben eine ausreichende Anzahl von Kopien hergestellt werden, da die Resistenz der Bildstellen gegen beispielsweise organische Lösemittel (als Farbkomponente) merklich verbessert wird.

2

Durch den Einbrennvorgang können die vor dem Einbrennen hydrophilen Nichtbildstellen der Druckform, d. h. die Stellen, an denen die hydrophile Oberfläche des Trägers durch Entwickeln freigelegt wurde, ihre Hydrophilie verlieren und dazu neigen, Farbe anzunehmen, wodurch es beim Drucken von diesen Druckformen auf den Hintergrundstellen der Drucke zu Verunreinigungen kommt.

Um den durch das Einbrennen entstehenden hydrophobierenden Effekt zu verhindern oder umzukehren, sind von zahlreichen Herstellern zusätzliche Verfahrensschritte für den Gesamtverfahrensablauf vorgeschlagen worden. Nachbehandlungsschritte wie erneutes Entwickeln, Reinigen der Platten oder chemisches Nachbehandeln der Platten wurden dafür vorgeschlagen. Außerdem werden Verfahrensschritte vor Einsatz der Einbrennstufe empfohlen, um eine Reduzierung der hydrophilien Oberflächeneigenschaften des Trägermaterials zu vermeiden.

Zu den Hilfsmitteln, die vor und/oder nach dem einbrennend-wirkenden thermischen Behandlungsschritt zum Einsatz kommen, zählen beispielsweise:

— wäßrige Fluorwasserstoffsäure, wäßrige Trinatriumphosphatlösung, wäßrige Phosphorsäure oder wäßrige Borfluorwasserstoffsäure zur Entfernung der beim Einbrennen entstehenden Verunreinigungen an den Nichtbildstellen der Druckplatte bzw. wäßrige Phosphorsäure zur Hydrophilierung der Nichtbildstellen vor dem Einbrennen gemäß der DE-B-1 447 963 (= GB-A-1 154 749) oder der DE-B-1 447 962 (= GB-A-1 151 199),

— wäßrige Lösungen von wasserlöslichen organischen Substanzen wie Gummi arabicum, Celluloseether, Polyacrylsäure, Salze organischer Säuren oder anionogene Tenside wie Alkylarylsulfonate und/oder von wasserlöslichen anorganischen Salzen wie Halogenide, Borate, Phosphate oder Sulfate zur Modifizierung der gesamten Plattenoberfläche (mit besonderer hydrophilierender Wirkung auf die Nichtbildstellen) vor dem Einbrennen gemäß der DE-A-2 626 473 (= GB-A-1 555 233),

— eine wäßrige Lösung von Polyvinylphosphonsäure zur Entfernung der beim Einbrennen entstehenden Verunreinigungen an den Nichtbildstellen der Druckplatte gemäß der DE-A-2 855 393,

— wäßrige Lösungen von Borsäure oder Boraten oder die entsprechenden Feststoffe zur Modifizierung der gesamten Plattenoberfläche vor oder während des Einbrennens gemäß der DE-A-2 625 336 (= US-A-4 063 507),

— wäßrige Lösungen von Salzen wie Natriumsalze organischer Sulfonsäuren oder Lithiumnitrat zur Modifizierung der gesamten Plattenoberfläche vor dem Einbrennen gemäß der DE-A-2 530 422 (= GB-A-1 513 368).

Die vor oder während des Einbrennens einsetzbaren Verbindungen zur Modifizierung der Plattenoberfläche unterliegen oftmals bei den anzuwendenden erhöhten Temperaturen selbst chemischen Veränderungen, die ihre beabsichtigte Wirkung, d. h. ihre hydrophilierende Wirkung aufgrund ihrer chemischen Struktur, zunichte machen können; auch eine Verminderung der Oleophilie der Bildstellen wurde beobachtet. Die Nachreinigung nach dem Einbrennen wird dagegen häufig mit sehr aggressiven Chemikalien wie Fluoriden durchgeführt, die neben ihrer Toxizität auch beispielsweise die Oxidschicht von Aluminiumträgern angreifen können.

Aufgabe der Erfindung ist es deshalb, das bekannte Verfahren zum Einbrennen von lichtempfindlichen Schichten so zu modifizieren, daß nur eine Behandlungsstufe zwischen Entwicklung und Einbrennen erforderlich ist, ohne daß dabei Nachteile beim späteren Drucken auftreten. In dieser behandlungsstufe soll verhindert werden, daß die Nichtbildstellen in zu großem Maße während des Einbrennens hydrophobiert werden, so daß durch diesen negativen Einfluß eine Nachbehandlung nach der Einbrennstufe erforderlich werden würde.

Die Erfindung geht aus von dem bekannten Verfahren zum Einbrennen von belichteten und entwikkelten lichtempfindlichen Schichten während der Herstellung von Offsetdruckformen mit einer zusätzlichen modifizierenden Behandlung der die Bild- und Nichtbildstellen aufweisenden Oberfläche der Druckform mit mindestens einer wasserlöslichen organischen Aminoverbindung zwischen der Entwicklungs- und der Einbrennstufe. Das erfindungsgemäße Verfahren ist dann dadurch gekennzeichnet, daß zur modifizierenden Behandlung eine wäßrige Lösung verwendet wird, die mindestens ein Carboxylgruppen enthaltendes Amin oder eines seiner Salze enthält.

Das erfindungsgemäße Verfahren läßt sich grundsätzlich für jede Offsetdruckplatte anwenden, die in der positiv oder negativ arbeitenden Schicht eine der üblichen lichtempfindlichen Verbindungen wie Diazo-, Diazonium- oder Azidoverbindungen oder photopolymerisierbare Verbindungen (siehe z. B. Jaromir Kosar, »Light-Sensitive Systems«, John Wiley & Sons, New York, 1965) enthält; insbesondere aber für solche Druckplatten, die in der positiv arbeitenden lichtempfindlichen Schicht mindestens eine Diazoverbindung als lichtempfindliche Komponente enthalten, insbesondere sind diese Verbindungen Ester oder Amide von o-Naphthochinondiazidsulfonsäuren oder o-Naphthochinondiazidcarbonsäuren (siehe beispielsweise die bereits eingangs erwähnte DE-B-1 447 963). Neben der Diazoverbindungs-Komponente enthalten die lichtempfindlichen Schichten normalerweise auch ein Harz, insbesondere einen Novolak und/oder ein Resol, es können aber auch verschiedene weitere Komponenten wie Farbstoffe oder Haftvermittler vorhanden sein.

Als Trägermaterialien für die lichtempfindlichen Schichten können die in der Offsetdrucktechnik

3

üblichen verwendet werden, dazu zählen, neben den für Einbrennverfahren wegen ihrer im allgemeinen ungenügend temperaturstabilen Zusammensetzung weniger geeigneten Folien aus organischen Polymeren wie Polyestern, insbesondere Metallfolien auf der Basis von Aluminium, Zink oder Stahl; bevorzugt werden Aluminiumplatten eingesetzt, die chemisch, mechanisch oder elektrochemisch aufgerauht sind und gegebenenfalls noch eine Aluminiumoxidschicht tragen. Oftmals wird das Druckplattenträgermaterial auch noch auf der Oberfläche vor dem Aufbringen der lichtempfindlichen Schicht modifiziert, beispielsweise mit wäßrigen Polyvinylphosphonsäure- oder Natriumsilikatlösungen.

Die vom Hersteller oder Verbraucher mit der lichtempfindlichen Schicht versehenen Druckplatten werden nach einem aus dem Stand der Technik bekannten Verfahren belichtet und entwickelt. Das kann beispielsweise Belichten mit UV-Strahlen durch eine Photomaske und Entwickeln mit einem wäßrig-alkalischen Entwickler beinhalten. Gemäß der Erfindung wird die entwickelte Druckplatte nun mit einer wäßrigen Lösung aus einem oder mehreren Carboxylgruppen enthaltenden Amin(en) oder dessen (deren) Salzen beschichtet und anschließend einer Einbrennbehandlung unterzogen. Es kann angenommen werden, daß durch die Hitze die nach dem Entwickeln auf der Platte verbleibenden Harze der Bildstellen vernetzt werden, wodurch das Bild verstärkt wird. Das Amin schützt die hydrophilen Nichtbildbereiche während des Einbrennens und verhindert, daß sie oleophil werden; möglicherweise ist diese Schutzfunktion darauf zurückzuführen, daß sich ein Oberflächenfilm auf dem Trägermaterial (z. B. Aluminium bzw. Aluminiumoxid) ausbildet. Nach dem Einbrennen ist keine chemische Nachbehandlung der Druckform mehr erforderlich. Die gute Schutzfunktion für die Hydrophile der Nichtbildstellen geht einher mit einer bleibenden Oleophilie der Bildstellen.

Beispiele für die im erfindungsgemäßen Verfahren einsetzbaren Amine sind Ethylendiamin-tetraessigsäure, Hydroxyalkyl-ethylendiamin-triessigsäure, Diethylentriamin-pentaessigsäure, Nitrilotriessigsäure oder die Natrium-, Kalium-, Lithium-, Calcium- oder Magnesiumsalze dieser Säuren. Derartige Carboxylgruppen enthaltenden Amine können entweder als solche vorliegen (z. B. Ethylendiamintetraessigsäure), oder einzelne Carboxylgruppen können durch aliphatische Verbindungen mit 2 bis 8 Kohlenstoffatomen substituiert sein (z. B. Hydroxyethylethylendiamin-triessigsäure). Gegebenenfalls können die erfindungsgemäß einzusetzenden Amine mit Säuren wie Schwefel-, Salpeter-, Phosphor-, Essig-, Citronen- oder Weinsäure gemischt werden. Dabei wird im Falle der Salze den Carboxylaten durch die zugesetzte Säure das Kation entzogen und durch ein Proton der Säure ersetzt, wobei die entsprechenden Aminocarbonsäuren entstehen. Das freiwerdende Kation kann dann mit der zugesetzten Säure reagieren, wobei ein komplexes Salz entsteht. Wird z. B. das Tetranatriumsalz der Ethylendiamin-tetraessigsäure mit Phosphorsäure gemischt, findet eine Reaktion statt, bei der an den Carboxylatgruppen des Amins ein oder zwei Natriumkationen durch Wasserstoff ersetzt werden, und das Natriumkation mit dem Phosphorsäureanion unter Bildung eines Mononatriumphosphats reagiert. Die erfindungsgemäß eingesetzte Lösung würde nach dem Trocknen demnach aus einem Gemisch einer Aminocarbonsäure und Mononatriumphosphat bestehen.

Die im erfindungsgemäßen Verfahren einzusetzende wäßrige Lösung weist in der Regel ein Konzentration an nichtwäßrigen Komponenten zwischen 0,1 und 40 Gew.-%, bevorzugt zwischen 0,1 und 15 Gew.-%, und besonders bevorzugt zwischen 0,1 und 7 Gew.-% auf. Der pH-Wert des Gemisches liegt gewöhnlich zwischen 2,5 und 9,0.

In einer zweckmäßigen Ausführung der Erfindung wird die wäßrige Lösung auf die Bildseite der Druckplatte einfach bei Raumtemperatur aufgetragen und trocknen gelassen. Auf die erfolgreiche praktische Anwendung des Verfahrens wirken sich unterschiedliche Beschichtungstemperaturen, Trockentemperaturen oder Trockenzeiten nicht merkbar nachteilig aus. Besonders gute Ergebnisse werden erzielt, wenn die modifizierende Vorbehandlungsstufe so durchgeführt wird, daß die aufgebrachte wäßrige Lösung nach dem Trocknen zu einer Schicht eines Gewichts von 10 g/m$^2$ oder mehr führt; selbstverständlich wird aus Gründen der Materialkostenersparnis wohl die kleinste zur Erzielung befriedigender Ergebnisse notwendige Menge verwendet werden. Diese Mindestmenge kann vom Fachmann ohne Schwierigkeiten bestimmt werden, sie liegt im Minimum bei 10 mg/$^2$, insbesondere bei 45 mg/m$^2$.

In einer Ausführungsform des erfindungsgemäßen Verfahrens wird die Druckplatte mit einem mit der wäßrigen Lösung getränkten Schwamm oder Wattetampon eingerieben; man kann die Druckplatte aber auch in eine mit der wäßrigen Lösung gefüllte Schale eintauchen oder ein anderes Verfahren dieser Art anwenden. Das Glätten des Überzuges aus der wäßrigen Lösung, z. B. mit Hilfe einer Gummirakel, sorgt für besonders gute Ergebnisse.

Die so behandelte Druckplatte wird anschließend in einem Ofen bei einer Temperatur von etwa 120° C bis 270° C bis zu einer Dauer von 45 min eingebrannt, üblichere Einbrennzeiten sind 2 bis 10 min. Das Einbrennen erfolgt gewöhnlich in einem speziell für Druckplatten entworfenen Ofen, z. B. einem von Azoplate, einem Unternehmen der American Hoechst Corporation (Somerville—USA) lieferbaren ®Encoven. Es sind aber auch in jüngerer Zeit andere thermische Behandlungsarten vorgeschlagen worden, beispielsweise eine Bestrahlung mit Quarz-Halogen-Lampen gemäß der DE-B-1 955 378 (= GB-A-1 330 139) oder mit Infrarot-Strahlung gemäß der DE-A-2 201 936 (= GB-A-1 413 374).

In den folgenden Beispielen verhalten sich Gew.-Teile zu Vol.-Teilen wie g zu cm$^3$, die Prozentangaben sind solche in Gew.-%.

4

## Beispiel 1

Eine mechanisch durch Schleifmittel und Bürsten aufgerauhte und anodisch oxidierte Aluminiumplatte wurde mit einer negativ arbeitenden lichtempfindlichen Beschichtung der folgenden Zusammensetzung versehen:

2,0 Gew.-Teile  Mischkondensat aus 1 Mol 3-Methoxy-diphenylamin-4-diazoniumsulfat und 1 Mol 4,4'-Bismethoxymethyl-diphenylether, hergestellt in 85%iger wäßriger Phosphorsäure und als Mesitylensulfonat ausgefällt,
0,5 Gew.-Teile  Polyvinylformal,
2,0 Gew.-Teile  Cyanophthalat-Pigment,
3,0 Gew.-Teile  85%ige Phosphorsäure, und
87,0 Vol.-Teile  Ethylenglykolmonomethylether.

Die so hergestellte Druckplatte wurde auf herkömmliche Weise belichtet, mit einem Entwickler aus 16,2 Gew.-Teilen n-Propanol, 5,6 Gew.-Teilen $MgSO_4$, 0,7 Gew.-Teilen Isooctylphenol-polyglykolether mit 4 Ethylenoxideinheiten und 77,5 Gew.-Teilen $H_2O$ entwickelt und in zwei Proben aufgeteilt. Probe 1 wurde in eine Druckmaschine gelegt, und es wurden 70 000 gute Drucke erzielt bis zum Bildzusammenbruch; es traten vorher bereits Tonprobleme auf. Probe 2 wurde mit einer 7%igen wäßrigen Lösung aus dem Natriumsalz der Ethylendiamin-tetraessigsäure beschichtet, getrocknet und bei 150° C während 5 min eingebrannt. Nach dem Abkühlen lieferte die Platte in einer Druckmaschine 200 000 gute Drucke ohne Tonprobleme bis zum Bildzusammenbruch. Es war nach dem Einbrennen keine Behandlung zum Entfernen des aufgebrachten Schutzfilms erforderlich. Die Bildstellen der Kopien waren vollständig gefärbt, und die Hintergrundstellen waren weder getont, noch traten Flecken auf.

## Beispiel 2

Eine mechanisch durch Schleifmittel und Bürsten aufgerauhte Aluminiumplatte wurde mit einer positiv arbeitenden lichtempfindlichen Schicht folgender Zusammensetzung versehen:

10,0 Gew.-Teile  des Kondensationsproduktes aus 2,3,4-Trihydroxybenzophenon und Naphthochinon-(1,2)-diazid-(2)-5-sulfochlorid,
2 Gew.-Teile  Kristallviolett
9 Gew.-Teile  eines durch Kondensation eines technischen Kresolgemischs mit Formaldehyd hergestellten Novolaks vom Erweichungspunkt 108° bis 118° C (nach DIN 53 181),
30 Vol.-Teile  Essigsäurebutylester, und
47 Vol.-Teile  Ethylenglykol-monoethylether-acetat.

Die so hergestellte Druckplatte wurde durch ein Positivtransparent belichtet, mit einer wäßrig-alkalischen Natrium-silikat enthaltenden Entwicklerlösung auf herkömmliche Art entwickelt und in zwei Proben aufgeteilt. Probe 1 wurde in eine Druckmaschine eingelegt, und es wurden 60 000 zufriedenstellende Kopien erhalten bis zum Bildzusammenbruch; es traten vorher bereits Tonprobleme auf. Probe 2 wurde mit einer 7%igen wäßrigen Lösung folgender Zusammensetzung der nichtwäßrigen Komponenten beschichtet und getrocknet:

3,6 Gew.-Teile  Tetranatriumsalz der Ethylendiamin-tetraessigsäure
3,6 Gew.-Teile  Trinatriumsalz der Hydroxyethyl-ethylen-diamin-triessigsäure
5,2 Gew.-Teile  Phosphorsäure, 85%ig

Die beschichtete Platte wurde dann in einem Ofen bei 140° C während 7 min eingebrannt und in eine Druckmaschine eingelegt. Es wurden 400 000 zufriedenstellende Kopien erhalten bis zum Bildzusammenbruch; es traten keine Tonprobleme auf.

## Patentansprüche

1. Verfahren zum Einbrennen von belichteten und entwickelten lichtempfindlichen Schichten während der Herstellung von Offsetdruckformen mit einer zusätzlichen modifizierenden Behandlung der die Bild- und Nichtbildstellen aufweisenden Oberfläche der Druckform mit einer wasserlöslichen organischen Aminoverbindung zwischen der Entwicklungs- und der Einbrennstufe, dadurch gekennzeichnet, daß zur modifizierenden Behandlung eine wäßrige Lösung verwendet wird, die mindestens ein Carboxylgruppen enthaltendes Amin oder eines seiner Salze enthält.

2. Verfahren nach Anspruch 1, dadurch gekennzeichnet, daß die wäßrige Lösung zusätzlich mindestens eine Säure aus der Gruppe Phosphorsäure, Salpetersäure, Essigsäure, Citronensäure, Weinsäure oder Schwefelsäure enthält.

3. Verfahren nach Anspruch 1 oder 2, dadurch gekennzeichnet, daß als Carboxylgruppen enthaltendes Amin Ethylendiamin-tetraessigsäure, Hydroxyalkyl-ethylendiamintriessigsäure, Diethylentriaminpentaessigsäure, Nitrolotriessigsäure oder das entsprechende Na-, K-, Li-, Ca- oder Mg-Salz eingesetzt wird.

4. Verfahren nach einem der Ansprüche 1 bis 3, dadurch gekennzeichnet, daß die wäßrige Lösung 0,1 bis 40 Gew.-%, insbesondere 0,1 bis 15 Gew.-%, nichtwäßriger Komponenten enthält.

## Claims

1. Process for burning-in exposed and developed lightsensitive layers during the manufacture of offsetprinting forms, comprising an additional modifying treatment of the surface of the printing form which shows the image and non-image areas, which is carried out using a water-soluble organic amino compound between the developing stage and the burning-in stage, wherein an aqueous solution which comprises at least one amine containing carboxyl groups or one of its salts is used for the modifying treatment.

2. The process as claimed in Claim 1, wherein the aqueous solution additionally comprises at least one acid selected from the group consisting of Phosphoric, nitric, acetic, citric, tartaric or sulfuric acids.

3. The process as claimed in Claim 1 or Claim 2, the carboxyl-group containing amine used comprises ethylene diamine tetra-acetic acid, hydroxyalkyl ethylene diamine tri-acetic acid, diethylene triamine penta-acetic acid, nitrilo tri-acetic acid or the corresponding Na, K, Li, Ca or Mg salt.

4. The process as claimed in any of Claims 1 to 3, wherein the aqueous solution comprises from 0.1 to 40% by weight, particularly from 0.1 to 15% by weight, of non-aqueous constituents.

## Revendications

1. Procédé de cuisson de couches photosensibles exposées et développées pendant la fabrication de formes d'impression offset avec un traitement modificateur supplémentaire de la surface de la forme d'impression présentant des endroits image et des endroits non-image avec un composé amino organique soluble dans l'eau entre le stade du développement et le stade de la cuisson, caractérisé en ce que pour le traitement modificateur, on utilise une solution aqueuse qui contient au moins une amine contenant des groupes carboxyle ou un de ses sels.

2. Procédé suivant la revendication 1, caractérisé en ce que la solution aqueuse contient en outre au moins un acide du groupe acide phosphorique, acide nitrique, acide acétique, acide citrique, acide tartrique ou acide sulfurique.

3. Procédé suivant les revendications 1 ou 2, caractérisé en ce que comme amine contenant des groupes carboxyle, on utilise l'acide éthylènediamine-tétracétique, l'acide hydroxyalkyl-éthylènediaminetriacétique, l'acide diéthylènetriamine-pentacétique, l'acide nitrilotriacétique ou le sel de Na, K, Li, Ca ou Mg correspondant.

4. Procédé suivant l'une des revendications 1 à 3, caractérisé en ce que la solution aqueuse contient 0,1 à 40% en poids, en particulier 0,1 à 15% en poids, de constituants non aqueux.